# EUROPEAN PATENT APPLICATION

(11) **EP 0 921 438 A1**
(43) Date of publication of application: **09.06.1999**
(21) Application number: 98204135.2
(22) Date of filing: 08.12.1998
(51) Int. Cl.: G03F 3/10, G03F 7/34

(54) **Positive working peel-developable color proofing system**

(30) Priority: 05.12.1997 US 985747
(71) Applicant: Bayer Corporation, Pittsburgh, PA 15219-2502 (US)
(72) Inventor: Koenigkramer, Rusty, New Jersey 08853-3601 (US); Wilczak, Wojciech A., New Jersey 07302 (US)
(74) Representative: Ramon, Charles Lucien

(57) **Abstract**

The present invention relates to a method for producing a positive image, using a positive-acting color proofing element comprising, sequentially, a strippable cover sheet; a crosslinked layer containing a polymer having phenolic groups; a color layer, containing a colorant, a polymeric binder, a polymerizable monomer and, optionally, a photoinitiator; a photoadhering layer containing polymerizable groups, and, optionally, a free radical photoinitiator; and a optional thermoplastic adhesive layer. In one embodiment the element is laminated to a development sheet, with at least one of the color layer and the photoadhering layer containing the photoinitiator. The element is exposed to actinic radiation through the strippable cover sheet or the development sheet. imagewise exposed through the cover sheet; and the composite peeled apart to thereby form a colored positive image on the cover sheet. The positive image is laminated to an adhering layer on a substrate and peeled apart leaving the positive image on the adhering layer of the receiver sheet. In another embodiment, the positive image is laminated to a temporary receiver sheet comprising a substrate and a photopolymerizable layer on the substrate. After laminating the cover sheet to the temporary receiver sheet, peeling apart the cover sheet and temporary receiver sheet, a positive image is transferred onto the temporary receiver sheet. After laminating the positive image on the temporary receiver sheet onto a permanent receiver sheet,
overall exposing and peeling away temporary receiver sheet the positive image is on the permanent receiver sheet.

## Description

### BACKGROUND OF THE INVENTION

### Field of the Invention

The present invention relates to color proofing films. More particularly, the present invention pertains to a positive working, peel-apart photosensitive element capable of producing positive images upon imagewise exposure to actinic radiation and subsequent peel-apart development. Such color proofing films produce multicolored positive images on a receiver sheet by successive imagewise exposures to actinic radiation and peel developments.

### Description of the Prior Art

In the field of lithographic printing, it is desirable to produce a multicolor proof to assist in correcting a set of color separation films prior to using them to produce metal based lithographic printing plates. The proof should reproduce the color quality that will ultimately be obtained during the printing process. The proof must be a consistent duplicate of the desired halftone image. Visual examination of a color proof should show the color rendition to be expected from a press printing using the color separations, and any defects on the separations which might need to be altered before making the printing plates.

It is known in the art to produce color proofs for multicolor printing by using a printing press or proof press. However, this procedure requires that all of the actual printing steps be performed including making expensive metal printing plates. As a result, this conventional method of color proofing is costly and time consuming.

Photoimaging processes can also be used to produce a color proof. There are two general types of photoimaging methods, namely the overlay type and the single sheet type. In the overlay type of color proofing method, an independent transparent plastic support is used for producing an image of each color separation film by applying a photosensitive solution of the corresponding color. A series of such supports carrying images of the corresponding colors are then superimposed upon each other over a white sheet to produce a color proofing composite. The primary advantage of the overlay method is that proofs can be made quickly and can serve as a progressive proof by combining any two or three colors in register. However, this type of color proofing method has the disadvantage that the superimposed plastic supports tend to darken the color proofing sheet. As a result, the impression of the color proofing composite thus prepared is vastly different from that of copies actually obtained with conventional printing presses and with proof presses. Examples of such overlay approaches are contained in U.S. Patents 3,136,637; 3,211,553; and 3,326,682.

In the single sheet type of color proofing method, a color proofing sheet is prepared by successively producing images of different colors from different color separation films on a single receiver sheet. This can be accomplished by sequentially applying colorants or colored, photosensitive layers to a single opaque support. This method more closely resembles the actual printing process and eliminates the color distortion inherent in the overlay system. Examples of such single sheet approaches are contained in U.S. Patents 3,574,049; 3,671,236; 4,260,673; 4,366,223; 4,650,738; 4,656,114; and 4,659,642.

Various processes for producing single sheet color proofs of an image embodying thermal transfer and photopolymerization techniques are known, for example, from U.S. Patents 3,060,023; 3,060,024; 3,060,025; 3,481,736; and 3,607,264.

Peel apart color proofing systems are also well known. U.S. patents 4,963,462; 5,049,476; 4,910,120 and 5,108,868 disclose peel developable, single sheet color proofing systems. U.S. Patent 4,489,154, discloses a process which produces a single layer color proof by peel development. The photosensitive material comprises a strippable cover sheet; a colored photoadherent layer; a nonphotosensitive organic contiguous layer; and a sheet support. The material is exposed and peel developed. The positive or negative image is transferred to a receiver base. A fresh layer of adhesive must be applied to the receptor for each subsequent transfer. U.S. patent 5,300,399 discloses a peel apart color proofing system to produce a negative-acting color proofing film. This element sequentially comprises a strippable cover sheet which is transparent to actinic radiation; a crosslinked release layer; a color layer; a photoadhering layer; a thermoplastic adhesive layer; and a receiver sheet. At least one of the color layer and the photoadhering layer contains a photoinitiator. A single sheet, negative working color proofing film having good image quality with high resolution is produced when exposed through the strippable cover sheet. The cover sheet is subsequently peeled away, removing the unexposed areas of the color layer and transferring the exposed areas of the color layer to the receiver sheet. Typical practice is to discard the cover sheet containing the unexposed areas of the color layer. It has now been unexpectedly found that a positive acting color proofing element can be obtained from a peel-developable color proofing system by using the unexposed areas removed by the strippable cover sheet from this element.

### SUMMARY OF THE INVENTION

The invention provides a method for producing a positive image which comprises:
(A) providing a photosensitive element which comprises, in order from top to bottom
   (i) a strippable, transparent cover sheet;
   (ii) a crosslinked layer, which comprises a polymer having phenolic groups;
   (iii) a color layer, which comprises an organic binder, a photopolymerizable monomer, a colorant, and optionally, a photoinitiator, wherein the binder is present in sufficient amount to bind the color layer components into a uniform film, wherein the optional photoinitiator, when present, is present in sufficient amount to initiate polymerization of the photopolymerizable monomer, wherein the photopolymerizable monomer is present in sufficient amount to provide image differentiation when the element is imagewise exposed to actinic radiation and wherein the colorant is present in an amount sufficient to uniformly color the color layer;
   (iv) a photoadhering layer, which comprises a photocrosslinkable polymer having ethyienicaily unsaturated, photocrosslinkabie groups and a molecuiar weight greater than about 3,000, a photopolymerizable monomer having at least one ethylenically unsaturated group, and an optional photoinitiator, wherein the optional photoinitiator, when present, is present in sufficient amount to initiate polymerization of the photopolymerizable monomer and the crosslinking of the photocrosslinkable polymer and wherein at least one of either the color layer or the photoadhering layer contains a photoinitiator; and
   (v) an optional thermoplastic adhesive layer;
(B) laminating the photosensitive element to a development sheet;
(C) imagewise exposing the color layer and the photoadhering layer to actinic radiation through the cover sheet;
(D) peeling apart the development sheet and the transparent cover sheet with the crosslinked phenolic layer, retaining unexposed areas of the color layer on the crosslinked phenolic layer of the cover sheet, and transferring the exposed areas of the color layer onto the development sheet via the photoadhering layer and optional adhesive layer, to thereby form a colored positive image on the cover sheet;
(E) providing a receiver sheet comprising a substrate and an adhering layer on the substrate;
(F) laminating the cover sheet to the receiver sheet by contacting the positive image on the crosslinked phenolic layer of the cover sheet to the adhering layer on the substrate;
(G) peeling apart the cover sheet and its crosslinked layer from the receiver sheet, leaving the positive image on the adhering layer of the receiver sheet; and
(H) optionally repeating steps (A) through (G) at least once wherein a positive image from another photosensitive element having at least one different colorant is transferred to the positive image previously produced on the receiver sheet.

The invention further provides a method for producing a positive image which comprises:
(A) providing a photosensitive element which comprises, in order from top to bottom
   (i) a strippable, cover sheet;
   (ii) a crosslinked layer, which comprises a polymer having phenolic groups;
   (iii) a color layer, which comprises an organic binder, a photopolymerizable monomer, a colorant, and optionally, a photoinitiator, wherein the binder is present in sufficient amount to bind the color layer components into a uniform film. wherein the optional photoinitiator, when present, is present in sufficient amount to initiate polymerization of the photopolymerizable monomer, wherein the photopolymerizable monomer is present in sufficient amount to provide image differentiation when the element is imagewise exposed to actinic radiation and wherein the colorant is present in an amount sufficient to uniformly color the color layer;
   (iv) a photoadhering layer, which comprises a photocrosslinkable polymer having ethylenically unsaturated, photocrosslinkable groups and a molecular weight greater than about 3,000, a photopolymerizable monomer having at least one ethylenically unsaturated group, and an optional photoinitiator, wherein the optional photoinitiator, when present, is present in sufficient amount to initiate polymerization of the photopolymerizable monomer and the crosslinking of the photocrosslinkable polymer and wherein at least one of either the color layer or the photoadhering layer contains a photoinitiator; and
   (v) an optional thermoplastic adhesive layer;
(B) laminating the photosensitive element to a transparent development sheet;
(C) imagewise exposing the color layer and the photoadhering layer to actinic radiation through the transparent development sheet;
(D) peeling apart the transparent development sheet and the cover sheet with the crosslinked phenolic layer, retaining unexposed areas of the color layer on the crosslinked phenolic layer of the cover sheet, and transferring the exposed areas of the color layer onto the development sheet via the photoadhering layer and optional adhesive layer, to thereby form a colored positive image on the cover sheet;
(E) providing a temporary receiver sheet comprising a substrate and a photopolymerizable layer on the substrate; the photopolymerizable layer comprising a photopolymerizable monomer, oligomer or polymer, and a photoinitiator, wherein the photoinitiator is present in sufficient amount to initiate polymerization of the photopolymerizable monomer, oligomer or polymer when exposed to actinic radiation and the photopolymerizable monomer, oligomer or polymer is present in sufficient amount to polymerize when exposed to actinic radiation;
(F) laminating the cover sheet to the temporary receiver sheet by contacting the positive image on the crosslinked phenolic layer of the cover sheet to the photopolymerizable layer on the substrate;
(G) peeling apart the cover sheet with its crosslinked layer, from the temporary receiver sheet, transferring the positive image onto the photopolymerizable layer of the temporary receiver sheet;
(H) optionally repeating steps (A) through (G) at least once wherein a positive image from another photosensitive element having at least one different colorant is transferred onto the positive image previously produced on the temporary receiver sheet;
(I) laminating the positive image on the temporary receiver sheet onto a permanent receiver sheet;
(J) overall exposing the positive image and the photopolymerizable layer through the substrate of the temporary receiver sheet; and
(K) peeling away the substrate of the temporary receiver sheet from the permanent receiver sheet thus leaving the exposed photopolymerizable layer and the positive image on the permanent receiver sheet.

### DETAILED DESCRIPTION OF THE PREFERRED EMBODIMENT

In the practice of the present invention, a photosensitive element is prepared by forming layers on a transparent cover sheet which are, sequentially, a crosslinked phenolic layer, a color layer, a photoadherent layer, and an optional thermoplastic adhesive layer.

In the preferred embodiment, the cover sheet may be composed of any suitable flexible sheet material which is dimensionally stable when undergoing the herein specified lamination and peeling processes. That is, it should have substantially no change in dimensions under heating in the range of from about 60°C to about 120°C during lamination. They may be transparent or non-transparent as required by the inventive method. In one embodiment of the invention it must be transparent to the actinic radiation to which the color layer and photoadhering layer are sensitive. A preferred material is polyethylene terephthalate. In the preferred embodiment, it has a thickness of from about 1 to about 10 mils, a more preferred thickness is from about 2 to about 5 mils and most preferably from about 2 to about 3 mils. Suitable films nonexclusively include Melinex 054, 504, 505, and 582 films available from ICI, and Hostaphan 4400, 4500, and 4540 films available from Hoechst Celanese Corporation. The surface of the support may be smooth or it may be provided with a matte texture as with Melinex 475 film. A smooth surface is preferred because a rough surface scatters actinic radiation and thereby reduces the resolution capability of the photosensitive element.

On the cover sheet is a crosslinked layer, which comprises a polymer having phenolic groups. The phenolic polymer can comprise, for example, a novolak (cresol-formaldehyde resin), polyhydroxystyrene homo- and co-polymer, or acrylic polymer containing phenolic groups etc. Crosslinking of the polymer can be achieved, for example, by the use of polyisocyanates, melamine-formaldehyde resins, urea-formaldehyde resins, epoxy resins, aziridine resins, acrylic monomers under suitable conditions of heat and/or light, etc. The crosslinked phenolic layer is applied from a solvent coating composition onto the cover sheet and should be insoluble in solvents used to coat the subsequent layer. Useful solvents include organic solvents as well as water.

A color layer is then applied to the crosslinked phenolic layer. It comprises a colorant, a binder, an optional photoinitiator and a polymerizable component which may be an ethylenically unsaturated monomer, polymer or oligomer having at least one and preferably more than one unsaturated groups. The color layer may be formed from a composition containing all of these components, or more preferably, the color layer is formed by coating an admixture of a binder and colorant onto the phenolic layer and the photoinitiator and polymerizable component diffuse into the color layer from a subsequently applied photoadherent layer.

The polymerizable component in the color layer and in the photoadhering layer preferably comprise addition polymerizable, non-gaseous (boiling temperature above 100°C at normal atmospheric pressure), ethylenically-unsaturated compounds containing at least one and preferably at least two terminal ethylenically unsaturated groups, and being capable of forming a high molecular weight polymer by free radical initiated, chain propagating addition polymerization. The most preferred compounds are acrylate or methacrylate monomers as are well known in the art. Suitable polymerizable monomers nonexclusively include triethylene glycol dimethacrylate, tripropylene glycol diacrylate, tetraethylene glycol dimethacrylate, diethylene glycol dimethacrylate, 1,4-butanediol diacrylate, 1,6-hexanediol dimethacrylate, pentaerythritol tetraacrylate, trimethylol propane triacrylate, trimethylol propane trimethacrylate, di-pentaerythritol monohydroxypentaacrylate, pentaerythritol triacrylate, bisphenol-A-ethoxylate dimethacrylate, trimethylolpropane ethoxylate triacrylate, trimethylolpropane propoxylate triacrylate, and bisphenol A diepoxide dimethacrylate. The monomers in the color and photoadhering layers can be the same or different.

The optional photoinitiator component used in the color layer and/or photoadhering layer includes any compound which liberate free radicals on stimulation by actinic radiation. Preferred photoinitiators nonexclusively include quinoxaline compounds as described in U.S. Patent 3,765,898; the vicinal polyketaldonyl compounds in U.S. Patent 2,367,660; the alpha-carbonyls in U.S. Patents 2,367,661 and 2,367,670; the acyloin ethers in U.S. Patent 2,448,828; the triarylimidazolyl dimers in U.S. Patent 3,479,185; the alpha-hydrocarbon substituted aromatic acyloins in U.S. Patent 2,722,512; polynuclear quinones in U.S. Patents 2,951,758 and 3,046,127; and s-triazines in U.S. Patents 3,987,037 and 4,189,323. The most preferred photoinitiators include 2,3-di(4-methoxyphenyl)quinoxaline, 9-phenylacridine, 2-biphenyl-4,6-bis-trichloromethyl-5-triazine, bis(2,4,5-triphenyl)imidazole, bis-trichloromethyl-s-triazines, thioxanthones, acetophenones and acyl phosphine oxides, and the derivatives of each of these. For this invention, the term derivatives means that the compound may have pendant groups provided they do not prevent the compound from effecting photoinitiation. The photoinitiator used in the color and/or photoadhering layer may be the same or different.

The color layer also contains a binder or binding resin which not only determines the hardness and/or flexibility of the coating but is also used to control the dry development. Binding resins found suitable for the color layer are polyvinyl acetates, styrene/maleic anhydride copolymers and their half esters; acrylic polymers and copolymers; polyamides; polyvinyl pyrrolidones; cellulose and its derivatives; phenolic resins; and the like. The most preferred binding resins are polyvinyl acetates and acetals, such as UCAR resins available from Union Carbide, and polyvinyl formal, polyvinyl butyral and polyvinyl propional.

The color layer contains a colorant which may be a dye or a pigment to provide color to the image areas. Preferred colorants for this invention are pigments rather than dyes. Light fast colorants are preferred. The pigments are typically dispersed with an organic binder in an organic solvent or mixture of organic solvents. The pigments may be organic or inorganic. They are ground to a small enough particle size to duplicate the particle size and color of equivalent inks. The median diameter is generally less than 1 micrometer. Nonexclusive examples of colorants usable in the present invention are as follows: Permanent Yellow G (C.I. 21095), Permanent Yellow GR (C.I. 21100), Permanent Yellow DHG (C.I. 21090), Permanent Rubine L6B (C.I. 15850:1), Permanent Pink F3B (C.I. 12433), Hostaperm Pink E (73915), Hostaperm Red Violet ER (C.I. 46500), Permanent Carmine FBB (12485), Hostaperm Blue B2G (C.I. 74160), Hostaperm Blue A2R (C.I. 74160), and Printex 25. Most of these are products of Hoechst AG. They can be used separately or blended for a desired color. Dyes may be included in the color layer to spectrally sensitize the photoinitiator, such as described in U.S. Patent 4,282,309 and 4,454,218, and European Patent Applications 0,179,448 and 0,211,615.

In the practice of the present invention, the photoinitiator component is preferably present in the color layer in an amount ranging from about 0.01 to about 20% based on the weight of the solids in the layer. A more preferred range is from about 0.1 to about 15%, most preferably from about 1 to about 10%.

In a preferred embodiment of the present invention, the colorant component is present in an amount sufficient to uniformly color the color layer. It is preferably present in an amount ranging from about 5 to about 50% based on the weight of the solids in the color layer. A more preferred range is from about 8 to about 40%.

In the practice of the of the present invention, the binder component is preferably present in the color layer in an amount sufficient to bind the components in a uniform mixture and a uniform film when it is coated on a substrate. It is preferably present in an amount ranging from about 10 to about 90% based on the weight of the solids in the color layer. A more preferred range is from about 20 to about 80%.

In the preferred embodiments, the polymerizable component is present in the color layer in an amount of from about 1 to about 60% by weight of the total solids in the color layer, more preferably from about 5% to about 50%.

Other ingredients which may be present in the color layer may include thermal polymerization inhibitors, tackifiers, oligomers, residual solvents, surfactants, inert fillers, antihalation agents, hydrogen atom donors, photoactivators, and optical brightening agents. A plasticizer may also be included in the color or photoadhering layer of this invention to prevent coating brittleness and to keep the composition pliable if desired. Suitable plasticizers include dibutylphthalate, triarylphosphate and substituted analogs thereof and preferably dioctylphthalate. The color layer is applied from a solvent coating composition to the crosslinked phenolic layer and dried. Organic solvents are preferred for the color layer because of the diverse solubility characteristics of the various components. Typical solvents nonexclusively include methyl ethyl ketone, 2-methoxyethanol, 1-methoxy-2-propanol, 4-hydroxy-4-methyl-2-pentanone, tetrahydrofuran, diacetone alcohol, and gamma-butyrolactone. In the preferred embodiment the dry color layer has a coating weight range of from about 0.1 to about 5 g/m², preferably from about 0.2 to about 2 g/m² and the crosslinked phenolic layer has a coating weight range of from about 0.1 to about 5 g/m², preferably from about 0.4 to 2.0 g/m².

Adhered to the color layer is the photoadhering layer. The photoadhering layer comprises a photocrosslinkable polymer having ethylenically unsaturated, photocrosslinkable groups and a molecular weight greater than about 3,000, a photopolymerizable monomer having at least one ethylenically unsaturated group, and an optional photoinitiator. At least one of either the color layer or the photoadhering layer contains a photoinitiator.

The optional photoinitiator for the photoadhering layer may comprise any of the photoinitiators described above as useful for the color layer. In the practice of the present invention, the photoinitiator component is preferably present in the photoadhering layer in an amount ranging from about 1 to about 20% based on the weight of the solids in the layer. A preferred range is from about 2 to about 15%, more preferably from about 3 to about 10%. The ethylenically unsaturated monomer having at least one unsaturated group may comprise the same materials listed above as useful for the color layer. The monomer is preferably present in the photoadhering layer in an amount ranging from about 5 to about 50% based on the weight of the solids in the layer. A preferred range is from about 10% to about 45%, more preferably from about 15 to about 40%.

The photoadhering layer preferably also comprises a photocrosslinkable polymer. Suitable photocrosslinkable polymers nonexclusively include a urethane adduct of polyvinyl butyral or other acetal resins containing hydroxy groups and isocyanatoethyl methacrylate, or reaction product of hydroxy-containing acetal resins with methacrylic anhydride, acrylic acid, acryloyl chloride, etc. Such a polymer has ethylenically unsaturated, photocrosslinkable groups and a molecular weight greater than about 3,000 and preferably from about 50,000 to about 200,000. Preferred photopolymerizable polymers comprise random units of 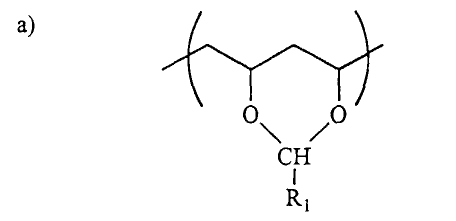 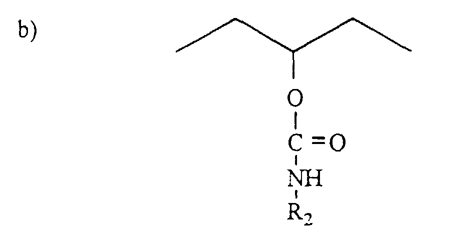 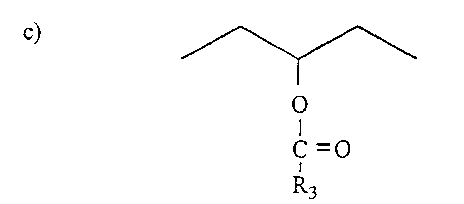 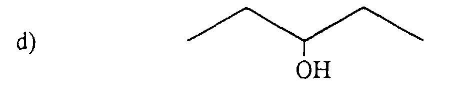 wherein
a = 50-99%
b = 1=30%
c = 0-30%
d = 0-50% and a+b+c+d = 100%
R₁ is a hydrogen atom or a substituted or unsubstituted alkyl radical having from 1 to about 6 carbon atoms, or a substituted or unsubstituted aryl radical;
R₂ is 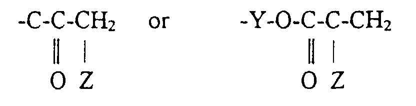 wherein Z is hydrogen or methyl and Y is a substituted or unsubstituted alkyl group having 1 to about 4 carbon atoms; and
R₃ is an alkyl radical having from 1 to about 4 carbon atoms. As used herein the term "substituted" means having a pendant group which does not detrimentally affect the photosensitive property of the polymer.

A preferred photocrosslinkable polymer is the reaction product of a polyvinyl acetal such as a polyvinyl butyral with a (meth)acrylated monoisocyanate such as acryloyl isocyanate, methacryloyl isocyanate or isocyanatoethyl methacrylate. Such a reaction may take place in an organic solvent unreactive with the isocyanate, such as tetrahydrofurane, methyl ethyl ketone or ethyl acetate. The reaction may optionally be catalyzed by such known catalysts as dibutyltin dilaureate. Acrylic polymers containing hydroxy groups can also be used with all the above (meth)acrylic groups-containing reagents, as can polyvinyl alcohols and their copolymers, phenolic resins, etc. Other reactive groups on polymers which can be (meth)acrylated nonexclusively include: amino, carboxyl, epoxy, etc. The (meth)acrylated polyvinyl acetal polymers are preferred. The photocrosslinkable polymer component is preferably present in the photoadhering layer in an amount of from about 3 to about 50%, more preferably from about 5% to about 40 % and most preferably from about 10 % to about 30 % by weight of the total solids in the photoadhering layer.

The photoadherent layer may optionally contain such other desired components as uv absorbers such as Uvinul D-50 available from GAF, antistatic compositions such as Gafac and Gafstat available from GAF, optical brighteners, inert fillers, thermal polymerizable inhibitors, residual solvents, surfactants, antihalation agents, hydrogen atom donors, tackifiers, and plasticizers such as Resoflex R-296, available from Cambridge Industries.

To form the photoadhering layer, the components may be dissolved in a solvent or mixture of solvents to facilitate application of the composition to the substrate. Suitable solvents for this purpose nonexclusively include water, tetrahydrofuran, n-butyl acetate, isobutyl isobutyrate, glycol ethers such as propylene glycol monomethyl ether and methyl cellosolve, alcohols such as ethanol and n-propanol and ketones such as methyl ethyl ketone. In general, the solvent composition is evaporated from the coating composition once it is applied to an appropriate substrate. However, some insignificant amount of solvent may remain as residue. In addition, the monomer from the photoadhering layer tends to diffuse into the color layer during overcoating process, so one way of providing the color layer with the monomer is not to include it in the coating solution of the color layer, but let it migrate there from the photo adhering layer during coating and drying process, or during lamination of the layers. This process of monomer migration via diffusion is known to those skilled in the art of creating multilayer imaging systems. According to the present invention, it is important that the monomer be present in the color layer when the element is exposed to actinic radiation, regardless of the way it became the part of the color layer. In the preferred embodiment, the photoadhering layer has a coating weight between about 2 and about 20 g/m². The most preferred weight is from about 3 to about 10 g/m².

The element next comprises an optional thermoplastic adhesive layer coated directly on the photoadhering layer. Preferred adhesive layers comprise thermoplastic resins coatable out of water. Such adhesives nonexclusively include Carboset acrylic resins, polyvinyl acetate/crotonic acid copolymers, polyvinyl pyrrolidone/polyvinyl acetate copolymers, polyvinyl acetate emulsions, styrene/maleic anhydride copolymers, urethane polymers, etc. The adhesive layer should be coated from a solvent which does not disturb the photoadhering layer underneath. Water is the preferred solvent. The adhesive layer may comprise a plasticizer which may be present in an amount of up to about 10% by weight and a uv absorber up to about 10% by weight. The coating weight of the layer should be from about 2 to about 20g/m², more preferably from about 5 to about 15 g/m², and most preferably from about 6 to about 10 g/m². In place of direct overcoating, one can assemble the hereinbefore described photosensitive element by hot-laminating the layers to each other, as is well known in the art. The adhesive layer should be transferable to a development sheet when laminated with pressure and heat in a temperature range of from about 50°C to about 180°C, preferably from about 60°C to about 120°C, more preferably from about 60°C to about 100°C.

Development sheets may comprise virtually any dimensionally stable support which can withstand the laminating and dry development processes and include those materials indicated above to be useful as cover sheet. They may be transparent or non-transparent as required by the inventive method. White plastic sheets, such as adhesion pretreated polyester Melinex 3020 film available from ICI, are useful for this purpose. Plastic coated paper sheets, such as polyethylene coated paper available from Schoeller, may also be used. Other bases may include wood, glass, metal, paper and the like.

Lamination of the photosensitive element to the development sheet may be conducted by putting either the photoadhering layer or the optional adhesive layer in contact with the development sheet and then introducing the materials into the nip of a pair of heated laminating rollers under suitable pressure. Suitable laminating temperatures usually range from about 60°C to about 120°C, preferably from about 70°C to about 100°C.

The element is then imagewise exposed through either the cover sheet or the development sheet, depending on which is transparent, by means well known in the art. Such exposure may be conducted by exposure to actinic radiation from a light source through a conventional halftone negative color separation under vacuum frame conditions. Mercury vapor discharge lamps are preferred over metal halide lamps. Other radiation sources, such as carbon arc, pulsed xenon, and lasers, may also be used. Light absorbing filters may be used to reduce light scattering in the materials.

In one embodiment, exposure occurs through the cover sheet. A positive image remains attached to crosslinked phenolic layer of the cover sheet by stripping the transparent cover sheet from the development sheet at room temperature with a steady, continuous motion. The preferred peel angle relative to the peel direction is greater than 90°. The delamination leaves the photoexposed areas of the color layer attached to the photoadhering layer, which in its entirety is transferred to the development sheet via the optional adhesive layer onto the development sheet. The nonexposed areas of the color layer remain on the crosslinked phenolic layer on the cover sheet which has been peeled apart from the development sheet.

Next, the cover sheet bearing the positive image is laminated to a receiver sheet having a substrate and an adhering layer on the substrate. This is done by contacting the positive image on the crosslinked phenolic layer of the cover sheet to the adhering layer on the substrate of the receiver sheet and laminating using heat and pressure. The cover sheet and crosslinked layer are subsequently peeled apart from the receiver sheet, leaving the colored positive image on the receiver sheet. This entire process, beginning with a new element with a different colored layer, is preferably repeated at least once to transfer at least one more positive image to the positive image previously produced on the receiver sheet.

Receiver sheets comprise a substrate coated with an adhering layer coated directly on the substrate. The substrate may comprise the same or similar material as a development sheet or a cover sheet. Thus includes virtually any dimensionally stable support which can withstand the laminating and dry development processes. White plastic sheets, such as adhesion pretreated polyester Melinex 3020 film available from ICI, are useful for this purpose. Plastic coated paper sheets, such as polyethylene coated paper available from Schoeller, may also be used. Other bases may include wood, glass, metal, paper and the like. Preferred adhering layers are thermoplastic adhesives that adhere more to the positive image. These preferred adhering layers include thermoplastic resins coatable out of water. Such adhesives nonexclusively include Carboset acrylic resins, polyvinylacetate/chloride copolymers, polyvinyl acetate/crotonic acid copolymers, polyvinyl pyrrolidone/polyvinyl acetate copolymers, polyvinyl acetate emulsions, styrene/maleic anhydride copolymers, urethane polymers, acrylic copolymers, etc. The adhesive layer should be coated from a solvent which does not disturb the photoadhering layer underneath. Water is the preferred solvent. The adhesive layer may comprise a plasticizer which may be present in an amount of up to about 10% by weight and a uv absorber up to about 10% by weight. The coating weight of the layer should be from about 2 to about 20g/m², more preferably from about 5 to about 15 g/m², and most preferably from about 6 to about 10 g/m². In place of direct overcoating, one can assemble the hereinbefore described photosensitive element by hot-laminating the layers to each other, as is well known in the art. The adhesive layer should be transferable to a receiver sheet when laminated with pressure and heat in a temperature range of from about 50°C to about 180°C, preferably from about 60°C to about 120°C, more preferably from about 60°C to about 100°C.

In another embodiment, exposure occurs through the development sheet. A positive image remains attached to crosslinked phenolic layer of the cover sheet by stripping the transparent cover sheet from the development sheet at room temperature with a steady, continuous motion. The delamination leaves the photoexposed areas of the color layer attached to the photoadhering layer, which in its entirety is attached to the development sheet via the optional thermoplastic adhesive layer on the development sheet. The nonexposed areas of the color layer remain on the crosslinked phenolic layer on the cover sheet which has been peeled apart from the development sheet.

Next, the cover sheet is laminated to a temporary receiver sheet which comprises a substrate and a photopolymerizable layer on the substrate. Temporary receiver sheet substrates may comprise any dimensionally stable material which is transparent to the actinic radiation. They may comprise the same or similar materials to the above cover sheets and development sheets and are preferably transparent. The photopolymerizable layer may comprise a photopolymerizable monomer, oligomer or polymer, a binder and a photoinitiator. The photoinitiator is present in sufficient amount to initiate polymerization of the photopolymerizable monomer, oligomer or polymer when exposed to actinic radiation. The photopolymerizable monomer, oligomer or polymer is present in sufficient amount to polymerize when exposed to actinic radiation. The binder may be present in an amount sufficient to bind the layer components in a uniform film. Suitable photopolymerizable monomers, oligomers, polymers, binders and photoinitiators and their amounts are described above as they are used in the other layers above. Lamination is done by contacting the positive image on the crosslinked phenolic layer of the cover sheet to the photopolymerizable layer of the temporary receiver sheet. The cover sheet and crosslinked layer are subsequently peeled apart from the temporary receiver sheet, transferring the colored positive image to the photopolymerizable layer of the temporary receiver sheet. This entire process, beginning with a new element with a different colored layer, is preferably repeated at least once to transfer at least one more positive image to the positive image previously produced on the temporary receiver sheet. Next, the temporary receiver sheet is laminated onto a permanent receiver sheet so that the positive image is in contact with the permanent receiver sheet. Lamination of the cover sheet to the permanent receiver sheet may be conducted in the same or similar manner as the above stated process of laminating the photosensitive element to a development sheet. The permanent receiver sheet may comprise the same or similar materials to the above cover sheets and development sheets. No adhesive is required on the permanent receiver sheet. The positive image and the photopolymerizable layer are then overall exposed either through the substrate of the temporary receiver sheet or the permanent receiver sheet, whichever is transparent. This causes in the photopolymerizable layer and positive image to be released from the temporary receiver sheet and attached to the permanent receiver sheet. Finally, the substrate of the temporary receiver sheet is peeled away from the permanent receiver sheet, leaving behind the exposed photopolymerizable layer and the positive image on the permanent receiver sheet.

In a full color proofing image, four distinct colored images are formed on a receiver sheet, namely magenta, cyan, yellow, and black. When the images are superimposed upon each other, a simulated full color reproduction results. In order to attain a multicolored image, multiple positive images produced from the above described photosensitive elements are laminated onto the first produced colored image. The final four color proof may be given a uniform, blanket exposure to photoharden the exposed, colored areas on the receiver base. A protective layer may also be laminated on top of the last dry developed layer.

The following nonlimiting examples serve to illustrate the invention.

### Example 1

### Photoadhering Layer Solution

To prepare the polymer with ethylenically unsaturated groups useful in photoadhering layer, 50 g ofButvar 79 polyvinyl butyral resin from Monsanto containing free hydroxyl groups (10.5-13%, expressed as % polyvinyl alcohol) was placed in 200 g of n-butyl acetate with stirring, at room temperature. To this solution, there were added 20 g of isocyanatoethyl methacrylate (Monomer, Polymer & Dajac Laboratories, Inc.), along with 0.05 g of dibutyltin dilaureate as catalyst. The mixture was left stirring overnight, and after that time no isocyanate band was seen in the IR spectrum of the polymer. Thus, a polymer containing methacrylate groups was created.

To 10 g of the above stock solution, there were added 0.38 g of Sartomer 399 Dipentaerythritol pentaacrylate (available from the Sartoma Co.), as monomer, and 0.1 g of 2-biphenyl-4,6-bis-trichloromethyl-s-triazine as initiator, completing the photoadhering layer formulation.

### Phenolic Layer Solution

1. Methyl Ethyl Ketone (MEK) - 47 g
2. Dowanol PM - 47 g
3. Poly-p-hydroxystyrene (6,200 MW, available from Hoechst Celanese Corporation) - 3 g
4. Melamine-formaldehyde resin (Cymel 303, Cyanamid) - 1 g
5. p-Toluene sulfonic acid - 0.2 g

This solution was coated on Melinex 505, 2 mil polyester available from ICI (strippable sheet) to coating weight of 0.5 g/m². The layer subsequently crosslinked upon drying in the oven at 110°C for 2 minutes.

### Color Layer Solution

1. Tetrahydrofuran - 21.7 g
2. Dowanol PM - 43.42 g
3. Diacetone alcohol - 16.18 g
4. Urethane adduct of 1 mole of trimethylhexamethylene diisocyanate with 2 moles of2-hydroxyethyl-4,6-bis-acryloxyethyl isocyanurate (Aronix M-215, Mitsui) - 3.38 g
5. 2-biphenyl-4,6-bis-trichloromethyl-s-triazine- 0.84 g
6. Magenta Formvar Dispersion (19.8% solution) (The Dispersion consists, in percent by weight, of: 80.2% gamma-butyrolactone, 9.0 FORMVAR 12/85 polyvinyl formal resin [available from Monsanto Co.]) and 10.8% Permanent Carmine FB) - 14.48 g

The color coat solution was coated on the crosslinked phenolic layer on the cover sheet and dried. The coating weight was 0.8 g/m². The color layer composition was then overcoated with the above photoadhering layer solution with a Meyer rod #24 and dried. The coating weight was 6.8 g/m².

The adhesive solution was Carboset XL-37 aqueous acrylic dispersion (available from B.F. Goodrich). It was coated on the photoadhering layer with a Meyer rod #15 and dried. The coating weight was 6 g/m².

The above-described photosensitive element was laminated to the support (the support was Pressmatch Commercial Receiver Base, available from Agfa Division, Bayer Corporation, using heat and pressure. The thusly prepared composite was imagewise exposed to actinic radiation through the transparent Strippable Sheet using a positive UGRA target for 15 seconds in a Berkey-Ascor exposure unit. Peeling away the strippable sheet resulted in exposed areas of the color coat staying on the photoadhering layer, which in its entirety remained attached to the support via the adhesive layer, while unexposed areas of the color coat were removed together with the strippable sheet and the entire phenolic layer. The dot reproduction was 3-97% at 150 lines per inch.

The strippable sheet bearing the crosslinked phenolic layer and the positive image consisting of unpolymerized parts of the color layer was then brought in contact with a receiver sheet, the color image facing the coated side of the receiver sheet.

The receiver sheet comprised, from top to bottom:
1. 10 mil thick filled polyester (Melinex 3020, ICI)
2. 12 micron thick adhering layer of polyvinyl acetate (Mowilith 30, Hoechst AG)

The two sheets were laminated together, using heat and pressure, and the strippable sheet was peeled away, carrying with it the entire crosslinked phenolic layer and leaving the positive magenta image on the receiver sheet.

### Example 2

This example shows a preparation of a four-color proof using the present invention. The formulations for the color layers include the following ingredients in parts by weight.

| Ingredient - Color Layer | Cyan | Yellow | Magenta | Black |
|---|---|---|---|---|
| Tetrahydrofuran | 200 | 200 | 200 | 200 |
| 4-hydroxy-4 -methyl pentanone | 150 | 150 | 150 | 150 |
| 1-methoxy-2-propanol | 444 | 465 | 489 | 490 |
| Formvar 12/85 resin | 12 | 13 | 15 | 18 |
| Sartomer 369 (Sartomer Co, Hydroxyethyl isocyanurate triacrylate monomer) | 10 | 12 | 16 | 15 |
| Hostaperm B2G | 14 | | | |
| Permanent Yellow GR | - | 14 | | |
| Permanent Red FBB | - | - | 24 | |
| Printex 25 | - | - | - | 24 |

The pigments were dispersed in Formvar 12/85 and solvents. The color solutions were coated on the crosslinked phenolic layer from Example 1 with a Meyer rod #12 and dried. The photoadhering solution from Example 1 was overcoated on each color layer with a Meyer rod #24, and dried, as was the Carboset XL-37 adhesive solution.

The procedure from Example 1 was followed, except this time three more positive images, each corresponding to a different color (Y,C,K), were transferred, in registration, onto the previously obtained magenta image on the receiver sheet. A 4-color positive proof resulted.

### Example 3

This example illustrates the use of a photosensitive receiver sheet.

A following receiver layer solution was prepared:
1. n-Butyl acetate - 74 g
2. Polyvinyl acetate (Mowilith 30, Hoechst AG) - 20 g
3. Dipentaerythritol pentaacrylate (Sartomer 399) - 5 g
4. 2,2-dimethoxy-1,2-diphenylethanone- 1 g

This solution was coated onto 10 mil thick filled polyester sheet (Melinex 3020, ICI) using Meyer rod # 24, and dried. The procedure from Example 2 was repeated, except the last color down was uniformly exposed to UV light after lamination to a receiver sheet and before peeling away the strippable sheet. This resulted in a scratch resistant, hardened proof.

### Example 4

This Example illustrates the use of the invention when the exposure of the photosensitive element is done through the support, and not through the strippable sheet.

Example 2 was repeated, only the support was replaced with a transparent, 2 mil polyester Melinex 6057 (ICI).
1. The element (strippable sheet, crosslinked phenolic layer, color layer, photosensitive layer, adhesive layer, 2 mil polyester support) was exposed to actinic radiation through the support through a positive UGRA target.
2. The strippable sheet, bearing the entire crosslinked phenolic layer and the unpolymerized areas of the color layer (wrong-reading) was separated from the support.
3. The strippable sheet was brought into contact with photopolymer temporary receiver sheet, the image facing the photopolymer surface, and laminated using heat and pressure.
4. The strippable sheet was than stripped away, taking with it the entire crosslinked phenolic layer and leaving the color positive image (wrong-reading) on the photopolymer surface of the temporary receiver sheet.
5. The temporary receiver sheet was brought into contact with the receiver sheet (plain paper), and laminated to it, using heat and pressure, the photopolymer surface and the color image facing the paper surface.
6. The element was blanket-exposed to actinic radiation and the temporary receiver sheet was peeled away.

## Claims

1. Method for producing a positive image which comprises :
(A) providing a photosensitive element which comprises, in order from top to bottom
(i) a strippable, transparent cover sheet;
(ii) a crosslinked layer, which comprises a polymer having phenolic groups;
(iii) a color layer, which comprises an organic binder, a photopolymerizable monomer, a colorant, and optionally, a photoinitiator, wherein the binder is present in sufficient amount to initiate polymerization of the photopolymerizable monomer, wherein the photopolymerizable monomer is present in sufficient amount to provide image differentiation when the element is imagewise exposed to actinic radiation and wherein the colorant is present in an amount sufficient to uniformly color the color layer;
(iv) a photoadhering layer, which comprises a photocrosslinkable polymer having ethylenically unsaturated, photocrosslinkable groups and a molecular weight greater than about 3,000, a photopolymerizable monomer having at least one ethylenically unsaturated group, and an optional photoinitiator, wherein the optional photoinitiator, when present, is present in sufficient amount to initiate polymerization of the photopolymerizable monomer and the crosslinking of the photocrosslinkable polymer and wherein at least one of either the color layer or the photoadhering layer contains a photoinitiator; and
(v) an optional thermoplastic adhesive layer;
(B) laminating the photosensitive element to a development sheet;
(C) imagewise exposing the color layer and the photoadhering layer to actinic radiation through the cover sheet;
(D) peeling apart the development sheet and the transparent cover sheet with the crosslinked phenolic layer, retaining unexposed areas of the color layer on the crosslinked phenolic layer of the cover sheet, and transferring the exposed areas of the color layer onto the development sheet via the photoadhering layer and optional adhesive layer, to thereby form a colored positive image on the cover sheet;
(E) providing a receiver sheet comprising a substrate and an adhering layer on the substrate;
(F) laminating the cover sheet to the receiver sheet by contacting the positive image on the crosslinked phenolic layer of the cover sheet to the adhering layer on the substrate;
(G) peeling apart the cover sheet and its crosslinked layer; from the receiver sheet, leaving the positive image on the adhering layer of the receiver sheet; and
(H) optionally repeating steps (A) through (G) at least once wherein a positive image from another photosensitive element having at least one different colorant is transferred to the positive image previously produced on the receiver sheet.

2. Method according to claim 1 further comprising the subsequent step (I) of overall exposing the positive image to actinic radiation.

3. Method for producing a positive image which comprises :
(A) providing a photosensitive element which comprises in order form top to bottom :
(i) a strippable, cover sheet;
(ii) a crosslinked layer, which comprises a polymer having phenolic groups;
(iii) a color layer, which comprises an organic binder, a photopolymerizable monomer, a colorant, and optionally, a photoinitiator, wherein the binder is present in sufficient amount to bind the color layer components into a uniform film, wherein the optional photoinitiator, when present, is present in sufficient amount to initiate polymerization of the photopolymerizable monomer, wherein the photopolymerizable monomer is present in sufficient amount to provide image differentiation when the element is imagewise exposed to actinic radiation and wherein the colorant is present in an amount sufficient to uniformly color the color layer;
(iv) a photoadhering layer, which comprises a photocrosslinkable polymer having ethylenically unsaturated, photocrosslinkable groups and a molecular weight greater than about 3,000, a photopolymerizable monomer having at least one ethylenically unsaturated group, and an optional photoinitiator, wherein the optional photoinitiator, when present, is present in sufficient amount to initiate polymerization of the photopolymerizable monomer and the crosslinking of the photocrosslinkable polymer and wherein at least one of either the color layer or the photoadhering layer contains a photoinitiator; and
(v) an optional thermoplastic adhesive layer;
(B) laminating the photosensitive element to a transparent development sheet;
(C) imagewise exposing the color layer and the photoadhering layer to actinic radiation through the transparent development sheet;
(D) peeling apart the transparent development sheet and the cover sheet with the crosslinked phenolic layer, retaining unexposed areas of the color layer on the crosslinked phenolic layer of the cover sheet, and transferring the exposed areas of the color layer onto the development sheet via the photoadhering layer and optional adhesive layer, to thereby form a colored positive image on the cover sheet;
(E) providing a temporary receiver sheet comprising a substrate and a photopolymerizable layer on the substrate; the photopolymerizable layer comprising a photopolymerizable monomer, oligomer or polymer; a binder; and a photoinitiator; wherein the photoinitiator is present in sufficient amount to initiate polymerization of the photopolymerizable monomer, oligomer or polymer when exposed to actinic radiation; the photopolymerizable monomer, oligomer or polymer is present in sufficient amount to polymerize when exposed to actinic radiation; and the binder is present in an amount sufficient to uniformly bind the photopolymerizable layer components in a uniform film;
(F) laminating the cover sheet to the temporary receiver sheet by contacting the positive image on the crosslinked phenolic layer of the cover sheet to the photopolymerizable layer on the substrate;
(G) peeling apart the cover sheet with its crosslinked layer, from the temporary receiver sheet, transferring the positive image onto the photopolymerizable layer of the temporary receiver sheet;
(H) optionally repeating steps (A) through (G) at least once wherein a positive image from another photosensitive element having at least one different colorant is transferred onto the positive image previously produced on the temporary receiver sheet;
(I) laminating the positive image on the temporary receiver sheet onto a permanent receiver sheet;
(J) overall exposing the positive image and the photopolymerizable layer through the substrate of the temporary receiver sheet; and
(K) peeling away the substrate of the temporary receiver sheet from the permanent receiver sheet thus leaving the exposed photopolymerizable layer and the positive image on the permanent receiver sheet.

4. Method according to claim 3 further comprising the subsequent step (L) of overall exposing the positive image to actinic radiation.

5. Method according to any of the preceding claims wherein the polymer having ethylenically unsaturated, photocrosslinkable groups and a molecular weight greater than 3,000 is present in the photoadhering layer in an amount of from about 10 to about 30 weight percent based on the weight of the non-solvents parts of the photoadherent layer.

6. Method according to any of the preceding claims wherein both the color layer and the photoadhering layer contain a photoinitiator.

7. Method according to claim 6 wherein the ethylenically unsaturated polymerizable component is delivered to the color layer by interlayer diffusion during assembly of the photosensitive element.

8. Method according to any of the preceding claims wherein the polymerizable monomer comprises one or more monomers selected from the group consisting of triethylene glycol dimethacrylate, tripropylene glycol diacrylate, tetraethylene glycol dimethacrylate, diethylene glycol dimethacrylate, 1,4-butanediol diacrylate, 1,6-hexanediol dimethacrylate, pentaerythritol tetraacrylate, di-pentaerythritol pentaacrylate, trimethylol propane triacrylate, trimethylol propane trimethacrylate, pentaerythritol triacrylate, bisphenol A ethoxylate dimethacrylate, trimethylolpropane ethoxylate triacrylate, trimethylolpropane propoxylate triacrylate, bisphenol A diepoxide dimethacrylate and bisphenol A diepoxide diacrylate.

9. Method according to any of the preceding claims wherein the photoinitiator comprises one or more photoinitiators selected from the group consisting of 2,3-di (4-methoxyphenyl)quinoxilane, 9-phenylacridine, 2-biphenyl-4, 6-bis-trichloromethyl-5-triazine, bis (2,4,5-triphenyl)imidazole, bis-trichloromethyl-s-triazine, acetophenones, thioxanthones, acyl phosphine oxides, and their derivatives.

10. Method according to any of the preceding claims wherein the color layer comprises one or more binding resins selected from the group consisting of styrene/maleic anhydride compolymers and their half esters; acrylic polymers and copolymers; polyamides; polyvinyl pyrrolidones; cellulosic resins; phenolic resins; polyvinyl acetals, polyvinyl acetates and their copolymers.

11. Method according to any of the preceding claims wherein the receiver sheet comprises paper, coated paper, or a polymeric film.

12. Method according to any of the preceding claims wherein the cover sheet comprises polyethylene terephthalate; the crosslinked layer comprises a crosslinked polyhydroxystyrene homopolymer or copolymer; the color layer comprises a urethane adduct of trimethylhexamethylene diisocyanate with 2-hydroxyethyl-4,6-bis-acryloxyethyl isocyanurate; the photoadhering layer comprises dipentaerythritol pentaacrylate and 2-biphenyl-4,6-bis-trichloromethyl-s-triazine and the receiver sheet substrate comprises paper or a white polymeric film.
